# EUROPEAN PATENT APPLICATION

(11) **EP 4 641 643 A1**
(43) Date of publication of application: **29.10.2025**
(21) Application number: 23910694.1
(22) Date of filing: 27.12.2023
(51) Int. Cl.: H01L 31/0236, H01L 21/02

(54) **PRE-TEXTURED SILICON WAFER AND PREPARATION METHOD THEREFOR, TEXTURED WAFER, AND SOLAR CELL**

(30) Priority: 30.12.2022 CN 202211732332
(71) Applicant: BYD Company Limited, Shenzhen, Guangdong 518118 (CN)
(72) Inventor: ZHOU, Wei, Shenzhen, Guangdong 518118 (CN); XU, Yucheng, Shenzhen, Guangdong 518118 (CN); ZHANG, Huan, Shenzhen, Guangdong 518118 (CN)
(74) Representative: Taor, Simon Edward William
(86) International application number: PCT/CN2023/142262
(87) International publication number: WO 2024/140775

(57) **Abstract**

Provided are a pre-textured silicon wafer and a preparation method thereof, a textured wafer, and a solar cell. The pre-textured silicon wafer includes a substrate layer and a pre-textured layer provided on a surface of at least one side of the substrate layer, the pre-textured layer includes a plurality of protrusions, the protrusions each are in a shape of a quadrangular frustum pyramid, and a length of a bottom edge of the protrusion ranges from 2 µm to 8 µm.

## Description

This application claims priority to Chinese Patent Application No. 202211732332.X, filed with the China National Intellectual Property Administration on December 30, 2022 and entitled "PRE-TEXTURED SILICON WAFER AND PREPARATION METHOD THEREOF, TEXTURED WAFER, AND SOLAR CELL", which is incorporated herein by reference in its entirety.

### TECHNICAL FIELD

This application relates to the field of solar cell technologies, and specifically, to a pre-textured silicon wafer and a preparation method thereof, a textured wafer, and a solar cell.

### BACKGROUND

Solar cells are one of the important ways to alleviate global energy crisis and environmental pollution. Heterojunction cells have gradually become a direction for future development of solar cells due to high photoelectric conversion efficiency, high bifaciality, almost no light-induced degradation, good temperature characteristics, and simple preparation processes. A heterojunction is formed through deposition of an amorphous silicon film on a crystalline silicon layer. Distribution of light trapping structures on a textured surface of the crystalline silicon layer directly affects cell performance.

At present, a silicon wafer for a heterojunction cell needs to undergo rough polishing, texturing, rounding, passivation with hydrofluoric acid, and other processes. Through the rough polishing process, a damage layer, on a surface of the silicon wafer, caused by a cutting process can be fully removed, and a light trapping structure can be formed on the silicon wafer during subsequent texturing based on a structure formed on the roughly polished surface of the silicon wafer. In the conventional technology, to fully remove the foregoing damage layer, a strong alkali with a concentration of about 5 wt% is usually used to roughly polish the silicon wafer. However, this causes a large size and low distribution density of finally formed light trapping structures, and a large difference in sizes of multiple light trapping structures, leading to an increase in internal resistance of a final cell, affecting normal cell performance.

### SUMMARY

In view of this, this application provides a pre-textured silicon wafer and a preparation method thereof. A textured wafer having a textured surface layer with high flatness and low contact resistance can be smoothly produced from the pre-textured silicon wafer. Therefore, the pre-textured silicon wafer can be used to provide a solar cell with excellent performance.

A first aspect of this application provides a pre-textured silicon wafer, including a substrate layer and a pre-textured layer provided on a surface of at least one side of the substrate layer. The pre-textured layer includes a plurality of protrusions, the protrusions each are in a shape of a quadrangular frustum pyramid, and a length of a bottom edge of the protrusion ranges from 2 µm to 8 µm.

The protrusion structure of the pre-textured silicon wafer is in the shape of the quadrangular frustum pyramid, and the length of the bottom edge of the protrusion structure is controlled to range from 2 µm to 8 µm. In this way, in a subsequent texturing process, the protrusions can form small and densely arranged light trapping structures, thereby improving flatness of a textured surface of a textured wafer and reducing contact resistance of the textured surface of the textured wafer. Therefore, the pre-textured silicon wafer can be used to provide a solar cell with low internal resistance.

In an embodiment, nucleation sites are distributed on a side wall of the protrusion.

In an embodiment, the nucleation site is a quadrangular pyramid with a maximum cross-sectional width ranging from 0 µm to 1 µm and a height ranging from 0 µm to 0.75 µm.

In an embodiment, the pre-textured layer includes 2 to 11 protrusions per 100 µm².

In an embodiment, a height of the protrusion ranges from 0.5 µm to 2 µm.

In an embodiment, a cross-sectional size of the protrusion gradually decreases in a direction facing away from the substrate layer.

A second aspect of this application provides a method for preparing a pre-textured silicon wafer, including the following steps:
subjecting a raw material of a textured wafer to sequential cleaning and alkaline polishing treatment to obtain the pre-textured silicon wafer, where the pre-textured silicon wafer includes a substrate layer and a pre-textured layer provided on a surface of at least one side of the substrate layer, the pre-textured layer includes a plurality of protrusions, and the protrusions each are in a shape of a quadrangular frustum pyramid; and
the alkaline polishing treatment includes the following conditions: the silicon wafer is subjected to alkaline etching with a strong alkali solution of 15 wt% to 30 wt%; and duration for the alkaline polishing treatment is 40s to 120s, and a temperature for the alkaline polishing treatment is 50°C to 80°C.

The preparation method has simple steps, high process reliability, and high production efficiency, and is applicable to large-scale industrial production.

In an embodiment, the subjecting the silicon wafer to sequential cleaning includes:
cleaning the silicon wafer with a first cleaning solution at a cleaning temperature of 60°C to 90°C for cleaning duration of 5 min to 20 min, where the first cleaning solution contains hydrogen peroxide and aqueous ammonia, a concentration of the aqueous ammonia is about 2 wt% to 10 wt%, and a concentration of the hydrogen peroxide is about 2 wt% to 10 wt%; and further cleaning the silicon wafer with a second cleaning solution at a cleaning temperature of 60°C to 90°C for cleaning duration of 5 min to 20 min, where the second cleaning solution is an aqueous solution of hydrochloric acid and hydrogen peroxide, and concentrations of both the hydrochloric acid and the hydrogen peroxide are 2 wt% to 10 wt%.

A third aspect of this application provides a textured wafer. The textured wafer is prepared from the pre-textured silicon wafer provided by the first aspect of this application. A textured surface of the textured wafer has high flatness, which facilitates deposition of another film layer (such as an amorphous silicon film layer or a transparent oxide layer) in a subsequent cell preparation process and subsequent close contact of another film layer with busbars and fingers.

In an embodiment, the textured wafer includes a substrate layer and a textured surface layer provided on a surface of at least one side of the substrate layer, the textured surface layer includes densely arranged light trapping structures, and a maximum cross-sectional width of the light trapping structure ranges from 1 µm to 4 µm.

In an embodiment, the light trapping structure is in a shape of a quadrangular pyramid; and a maximum cross-sectional size of the light trapping structure gradually decreases in a direction facing away from the substrate layer.

In an embodiment, the textured surface layer includes 60 to 100 light trapping structures per 100 µm².

In an embodiment, a height of the light trapping structure ranges from 1.23 µm to 1.58 µm.

In an embodiment, adjacent light trapping structures are arranged at no interval.

A fourth aspect of this application provides a solar cell, including the textured wafer provided by the third aspect of this application.

### BRIEF DESCRIPTION OF THE DRAWINGS

FIG. 1 is a diagram of a principle of gradual formation of light trapping structures from protrusions in a texturing process;
FIG. 2A is a scanning electron microscopy (scanning electron microscopy, SEM) image of a pre-textured silicon wafer according to Example 1 of this application;
FIG. 2B is an SEM image of a cross-section of a pre-textured silicon wafer according to Example 1 of this application;
FIG. 2C is an SEM image of a cross-section of a textured wafer according to Example 1 of this application;
FIG. 3A is an SEM image of a cross-section of a pre-textured silicon wafer according to Example 5 of this application;
FIG. 3B is an SEM image of a cross-section of a textured wafer according to Example 5 of this application;
FIG. 4A is an SEM image of a cross-section of a pre-textured silicon wafer according to Comparative Example 1 of this application;
FIG. 4B is an SEM image of a cross-section of a textured wafer according to Comparative Example 1 of this application;
FIG. 5 is an image of an electrode pattern for testing contact resistance between each textured wafer and an electrode according to this application; and
FIG. 6 is a diagram of a structure of a solar cell.

### DESCRIPTION OF EMBODIMENTS

Embodiments of this application provide a pre-textured silicon wafer 1, including a substrate layer 10 and a pre-textured layer provided on a surface of at least one side of the substrate layer. The pre-textured layer includes a plurality of protrusions 201, the protrusions each are in a shape of a quadrangular frustum pyramid, and a length of a bottom edge of the protrusion ranges from 2 µm to 8 µm. It may be understood that, in this application, a length of a bottom edge of a protrusion is a length of an intersection line between the protrusion and the substrate layer, that is, a maximum cross-sectional width of the protrusion.

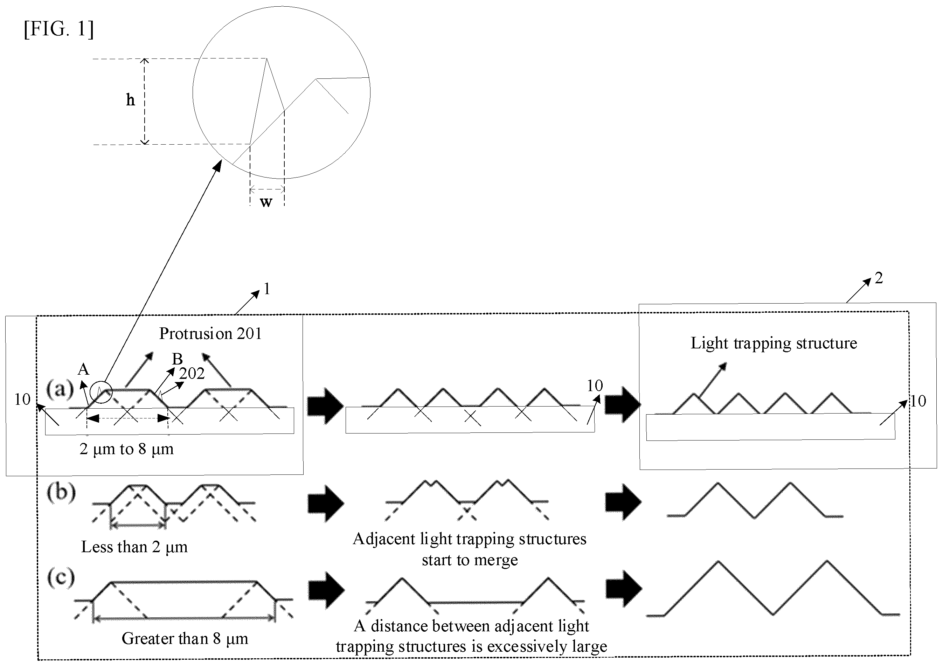

Refer to FIG. 1. A pre-textured layer of a pre-textured silicon wafer includes multiple protrusions "in a shape of a quadrangular frustum pyramid". In a subsequent texturing process, a texturing solution further corrodes the protrusions to gradually form light trapping structures, as shown in (a) in FIG. 1. An outline drawn by a black dotted line in the figure represents an outline of a front view of a light trapping structure that can be formed theoretically. The length of the bottom edge of the protrusion is controlled to be within the foregoing range, so that merging of adjacent light trapping structures is not likely to occur when the protrusions are further etched to form the light trapping structures during subsequent texturing, thereby controlling a size of the light trapping structure. In this case, the finally obtained light trapping structures have small sizes, high distribution density, and uniform size distribution, and thus the textured surface has high flatness and low contact resistance. Therefore, the pre-textured silicon wafer can be used to provide a solar cell with low internal resistance and high photoelectric conversion efficiency.

As shown in (b) in FIG. 1, if the length of the bottom edge of the protrusion is excessively small (less than 2 µm), merging of adjacent growing light trapping structures is likely to occur to finally form a light trapping structure with an excessively large size, leading to a small quantity and low density of light trapping structures on a final textured surface. This results in large undulation and low flatness of the textured surface, and a large difference in sizes of multiple light trapping structures. Consequently, internal resistance of a final solar cell is excessively large. As shown in (c) in FIG. 1, if the length of the bottom edge of the protrusion is excessively large (greater than 8 µm), a growing light trapping structure cannot be affected by steric hindrance from other growing light trapping structures, leading to large sizes, a small quantity, and low density of light trapping structures on a final textured surface, and resulting in excessively large undulation of the surface of the textured layer. This is also not conducive to the performance of a final solar cell.

For example, the length of the bottom edge of the protrusion may be 2 µm, 2.2 µm, 2.5 µm, 2.8 µm, 3 µm, 3.5 µm, 4 µm, 4.5 µm, 5 µm, 5.5 µm, 6 µm, 6.5 µm, 7 µm, 7.5 µm, 8 µm, or the like.

In some implementations of this application, nucleation sites 202 are distributed on a side wall of the protrusion. In this way, during subsequent texturing, based on the nucleation site, the texturing solution can more easily etch the protrusions to smoothly form light trapping structures that are "small and dense, with uniform size distribution". In this application, in some implementations, the nucleation site 202 is specifically a small bulge structure with a maximum cross-sectional width w greater than 0 µm and less than or equal to 1 µm and with a height h greater than 0 µm and less than or equal to 0.75 µm. In some implementations, the small bulge is in a shape of a quadrangular pyramid, that is, a "small pyramid". In a scanning electron microscopy (scanning electron microscopy, SEM) image of the pre-textured silicon wafer, due to an apparent tip effect and edge effect on the contrast of secondary electrons or backscattered electrons, the nucleation site appears as a "small white spot" at a specific scale (for example, 1 µm). In some other embodiments, the nucleation site 202 may be a spot-shaped structure with a maximum cross-sectional width w equal to 0 and a height h equal to 0 that is attached to a side wall A and a side wall B of a protrusion.

In some implementations of this application, a height of the protrusion ranges from 0.5 µm to 2 µm. In this way, when the nucleation site on the side wall starts to "grow", the height of the protrusion is controlled to be within the foregoing range, so that a distance between any points respectively on the side wall A and the side wall B that are provided opposite to each other on the protrusion can be within an appropriate range. In other words, a distance between a nucleation site on the side wall A and a nucleation sites on the side wall B of the protrusion is controlled to be within an appropriate range. This is more conducive to obtaining a textured wafer with high surface flatness. For example, the height of the protrusion may be 0.5 µm, 0.6 µm, 0.7 µm, 0.8 µm, 0.9 µm, 1 µm, 1.2 µm, 1.5 µm, 1.8 µm, 1.9 µm, 2 µm, or the like.

In some implementations of this application, a cross-sectional size of the protrusion gradually decreases in a direction facing away from the substrate layer. In this way, the "quadrangular frustum pyramid" is provided uprightly on the substrate layer, so that the obtained light trapping structure is also provided uprightly on the substrate layer, which is more conducive to multiple times of absorption of light.

In some implementations of this application, the pre-textured layer includes 2 to 11 protrusions per 100 µm². In this way, the protrusion structures on the pre-textured layer are distributed densely, so that the nucleation sites have more appropriate distribution density, which is more conducive to obtaining a textured wafer with high surface flatness. For example, a quantity of protrusions of the pre-textured layer per 100 µm² may be 2, 3, 4, 5, 6, 7, 8, 9, 10, 11, or the like.

In some implementations of this application, when a raw material of the silicon wafer is crystalline silicon, a first crystal face of the crystalline silicon is exposed on a side wall of the protrusion; and a second crystal face of the crystalline silicon is exposed on an upper surface of the protrusion.

An embodiment of this application provides a method for preparing a pre-textured silicon wafer, to prepare the pre-textured silicon wafer provided in the embodiments of this application. The preparation method includes the following steps.

A raw material of a textured wafer is subjected to sequential cleaning and alkaline polishing treatment to obtain the pre-textured silicon wafer. The alkaline polishing includes the following conditions: a surface on at least one side of the raw material of the textured wafer is etched with a strong alkali with a concentration of 15 wt% to 30 wt%; and duration for the alkaline polishing is 40s to 120s, and a temperature for the alkaline polishing is 50°C to 80°C. In this way, the obtained pre-textured silicon wafer includes a substrate layer and a pre-textured layer provided on a surface of at least one side of the substrate layer, the pre-textured layer includes a plurality of protrusions, and the protrusions each are in a shape of a quadrangular frustum pyramid.

During the foregoing alkaline polishing, 15 wt% to 30 wt% of strong alkali etches the first crystal face and the second crystal face of the crystalline silicon simultaneously at equivalent corrosion rates, which can quickly etch away a damage layer of the crystalline silicon. In addition, the first crystal face of the crystalline silicon is vertical, and the second crystal face has an inclination angle of about 54°. In this case, during the alkaline polishing, a tetrahedral structure is continuously formed on the surface of the crystalline silicon, and the alkali solution continuously corrodes a top of the tetrahedral structure to form a flat top surface. Therefore, the protrusion in the shape of the quadrangular frustum pyramid is obtained through etching in continuous balance of the two corrosion directions. If the concentration of the alkaline polishing solution is excessively low, corrosion rates on different crystal faces of the crystalline silicon are different, so that the protrusion in the shape of the quadrangular frustum pyramid cannot be obtained, which is not conducive to preparing a textured wafer with high flatness. If the concentration of the alkaline polishing solution is excessively high, corrosiveness is excessively strong, resulting in an excessively long edge of the protrusion in the shape of the quadrangular frustum pyramid, which is not conducive to obtaining a uniform textured surface.

In addition, the duration for alkaline polishing and the temperature for alkaline polishing are controlled respectively to be 40s to 120s and 50°C to 80°C. With a synergistic effect of the three factors: the concentration of the alkaline polishing solution, the duration for alkaline polishing, and the temperature for alkaline polishing, the length of the bottom edge of the protrusion (that is, the maximum cross-sectional width of the protrusion) can be controlled to range from 2 µm to 8 µm, so that a textured surface with high flatness can be obtained subsequently. If the duration for alkaline polishing is less than 40s, the amount of etching is not sufficient to fully remove a damage layer (that is, there are apparently many cutting lines left on the surface of a final textured wafer) and to obtain the foregoing protrusions. If the duration for alkaline polishing is greater than 120s, the amount of etching is excessively large, resulting in an excessively large length of the bottom edge of each protrusion, and consequently a textured surface with high flatness cannot be obtained. If the temperature for alkaline polishing is excessively low, the foregoing protrusion structure in the shape of the quadrangular frustum pyramid cannot be obtained, and a damage layer cannot be fully removed. It may be understood that an etching rate increases as the temperature for alkaline polishing increases. However, if the temperature for alkaline polishing is excessively high, the etching rate is excessively high, making process conditions uncontrollable, so that the shape and size of the protrusion cannot be regulated.

For example, the duration for alkaline polishing may be 40s, 50s, 60s, 70s, 80s, 90s, 100s, 110s, 120s, or the like.

For example, the temperature for alkaline polishing may be 50°C, 52°C, 55°C, 57°C, 60°C, 62°C, 65°C, 68°C, 70°C, 72°C, 75°C, 78°C, or the like.

The foregoing preparation method has simple steps and strong process reliability. Therefore, a damage layer of the silicon wafer can be removed efficiently and fully, where "fully removing the damage layer" means that almost no cutting lines are observed on a final product, and protrusions of appropriate sizes can be obtained, so that the nucleation sites can expand to form light trapping structures of appropriate sizes.

In some implementations of this application, the alkali solution further etches a side wall of a protrusion to form nucleation sites on the side wall of the protrusion. In this way, it is conducive to obtaining the textured surface layer with high flatness more smoothly from the pre-textured layer.

Embodiments of this application further provide a textured wafer 2, including a substrate 10 and a textured surface provided on a surface of at least one side of the substrate, the textured surface layer includes densely arranged light trapping structures, and a maximum cross-sectional width of the light trapping structure ranges from 1 µm to 4 µm. For example, the maximum cross-sectional width of the light trapping structure may be 1 µm, 1.2 µm, 1.5 µm, 1.8 µm, 2 µm, 2.5 µm, 3 µm, 3.5 µm, 3.8 µm, or the like.

These light trapping structures are densely arranged on the surface of the textured wafer like mountains. After incident light is incident on the first point on a side surface of a light trapping structure, reflected light is incident again on a surface of a neighboring light trapping structure to implement the second light absorption, and further implement n times of light absorption subsequently. In particular, light can be more easily reflected and absorbed for multiple times among different light trapping structures due to the small size and large density of the foregoing light trapping structures, so that the textured wafer can provide low reflectance. In addition, the formed textured surface has small undulation and high flatness due to the small size and large density of the light trapping structures, which facilitates deposition of another film layer (such as an amorphous silicon film layer or a transparent oxide layer) in a subsequent cell preparation process and subsequent close contact of another film layer with busbars and fingers, thereby helping reduce internal resistance of the cell, and further helping improve photoelectric conversion efficiency of the cell.

In this application, the textured wafer may include textured surface layers on both opposite surfaces, or may include a textured surface layer on one surface and a polished surface on the other surface.

In some implementations of this application, the textured surface layer includes 60 to 100 light trapping structures per 100 µm². In this way, the density of the light trapping structures on the textured surface layer is within a more appropriate range, which is more conducive to improving flatness of the textured surface, and is thus conducive to further improving photoelectric conversion efficiency of the cell. For example, a quantity of light trapping structures of the textured surface layer per 100 µm² may be 60, 65, 70, 75, 80, 85, 90, 95, 100, or the like.

In some implementations of this application, adjacent light trapping structures are arranged at no interval. It may be understood that there is a clear boundary, but almost no gap, between a bottom edge of a light trapping structure and a bottom edge of a neighboring light trapping structure. In this way, the density of the light trapping structures on the textured surface layer is higher, and the flatness of the textured surface is higher, which is more conducive to improving photoelectric conversion efficiency of a final solar cell.

In some implementations of this application, the light trapping structure is in a shape of a quadrangular pyramid; and a maximum cross-sectional size of the light trapping structure gradually decreases in a direction facing away from the substrate layer. In this way, the light trapping structure is in an upright "pyramid" shape, which is more conducive to multiple times of absorption of light. In this application, the "shape of the quadrangular pyramid" specifically means that the light trapping structure as a whole is in the shape of the quadrangular pyramid, but with straight or curved side edges and flat or curved side walls. In this case, the maximum cross-sectional width of the light trapping structure is a length of a bottom edge of the quadrangular pyramid structure, that is, an intersection line between the quadrangular pyramid structure and the substrate layer.

In some implementations of this application, a height of the light trapping structure ranges from 1.23 µm to 1.58 µm. In this way, the undulation of the textured surface layer is also controlled to be within the foregoing range, resulting in higher flatness of the textured surface layer. In addition, a light trapping structure in a shape of a quadrangular pyramid is used as an example, a length of a bottom edge of the light trapping structure ranges from 1 µm to 4 µm, and a height of the light trapping structure is controlled to be within the foregoing range, so that an inclination angle between a side wall of the light trapping structure and the substrate layer is also controlled to be within an appropriate range that is more conducive to multiple times of absorption of light. For example, the height of the light trapping structure may be 1.23 µm, 1.25 µm, 1.27 µm, 1.3 µm, 1.32 µm, 1.35 µm, 1.37 µm, 1.4 µm, 1.42 µm, 1.45 µm, 1.47 µm, 1.5 µm, 1.52 µm, 1.55 µm, 1.58 µm, or the like.

In some specific implementations, the preparation of the foregoing textured wafer includes the following steps:
S01: Clean a silicon wafer with a cleaning solution 1 (also referred to as a first cleaning solution) at a cleaning temperature of 60°C to 90°C for cleaning duration of 5 min to 20 min, where the cleaning solution 1 contains hydrogen peroxide and aqueous ammonia, a concentration of the aqueous ammonia is about 2 wt% to 10 wt%, and a concentration of the hydrogen peroxide is about 2 wt% to 10 wt%. It may be understood that organic contamination is inevitably introduced during production, transportation, and storage of the silicon wafer, and these organic contaminants hinder subsequent processes. The hydrogen peroxide can oxidize and decompose the organic contaminants into small molecules, and the aqueous ammonia can complex with the small molecules and dissolve the small molecules. Therefore, the organic contaminants are removed.
S02: Further clean the silicon wafer with a cleaning solution 2 (also referred to as a second cleaning solution) at a cleaning temperature of 60°C to 90°C for cleaning duration of 5 min to 20 min, where the cleaning solution 2 is an aqueous solution of hydrochloric acid and hydrogen peroxide, and concentrations of both the hydrochloric acid and the hydrogen peroxide are 2 wt% to 10 wt%. It may be understood that there are metal contaminants remaining on the surface of the silicon wafer. A metal introduces an intermediate level into a band gap of monocrystalline silicon and serves as a strong carrier recombination center. The foregoing metal contaminants can be removed by using a strong acid and a strong oxidant.
S03: Alkaline polishing. Subject the silicon wafer to sequential cleaning and alkaline polishing treatment to obtain a pre-textured silicon wafer. The pre-textured silicon wafer includes a substrate layer and a pre-textured layer provided on a surface of at least one side of the substrate layer, the pre-textured layer includes a plurality of protrusions, the protrusions each are in a shape of a quadrangular frustum pyramid, and nucleation sites are distributed on at least a side wall of the protrusion.
The alkaline polishing treatment includes the following conditions: the silicon wafer is subjected to alkaline etching with a strong alkali solution of 15 wt% to 30 wt%; and duration for the alkaline polishing treatment is 40s to 120s, and a temperature for alkaline polishing is 50°C to 80°C.
S04: Pre-cleaning. A pre-cleaning solution is a mixed solution of KOH and H₂O₂. A concentration of KOH is about 0.5 wt% to 5 wt%, and a concentration of H₂O₂ is about 1 wt% to 10 wt%. A temperature for the cleaning is 40°C to 80°C, and duration for the cleaning is about 120s to 360s. It may be understood that the surface of the silicon wafer is inevitably stained with organic substances, for example, oil contaminants, due to the previous process, which affects subsequent contact between a texturing solution and the silicon wafer, so that the organic substances need to be removed. In this case, H₂O₂ can oxidize the organic substances, and dilute KOH can dissolve the oxidized organic substances.
S05: Texturing. A texturing temperature is about 60°C to 90°C, and texturing duration is 6 min to 15 min. A texturing solution is a mixed solution of a strong alkali and an organic additive. A concentration of the strong alkali (KOH and/or NaOH) is about 1 wt% to 10 wt%. In some specific embodiments, the texturing solution further includes an organic additive (such as glycerol, ethylene glycol, or propanol). A percentage by mass of the organic additive in the texturing solution is greater than 0 wt% and less than or equal to 5 wt%. With the texturing solution in this concentration range, the crystalline silicon can be etched anisotropically, and the foregoing protrusion structure can be etched into a light trapping structure of a "pyramid" structure, to obtain a textured surface layer.
S06: First post-cleaning. The process parameters are the same as those in S04, and the same pre-cleaning solution is used. The remaining organic additive from the foregoing texturing process can be removed.
S07: Rounding. Sharp edges are formed at the top and bottom of the "pyramid" through the texturing process. This structure is not conducive to subsequent film coating and screen printing processes. In the rounding process, the sharp edges are transformed through acid etching into rounded corners with specific curvature. An etching solution used is an aqueous solution of concentrated nitric acid and hydrofluoric acid. A percentage by volume of hydrofluoric acid is less than 1%. A temperature for the process is 5°C to 20°C, and duration for the process is 1 min to 10 min.
S08: Second post-cleaning. After the previous process, there may still be metal contaminants remaining on the surface of the silicon wafer, which need to be removed. A temperature for the cleaning is 50°C to 70°C, and duration for the cleaning is 1 min to 3 min. A cleaning solution used is an aqueous solution of hydrochloric acid and hydrogen peroxide, and concentrations of both the hydrochloric acid and the hydrogen peroxide are 1 wt% to 10 wt%.
S09: Passivation with hydrofluoric acid. After the previous process, the textured wafer has been prepared. However, the silicon wafer naturally oxidizes in the air to produce a thin layer of silicon dioxide. In this case, the silicon wafer is immersed in hydrofluoric acid to form, on the surface of the silicon wafer, a protective film composed of a single layer of fluorine atoms, preventing oxidation of the silicon wafer. Then, the textured wafer is slowly lifted from water with no water droplets left.
S10: Drying. After all the processes, the textured wafer is blown dry with nitrogen.

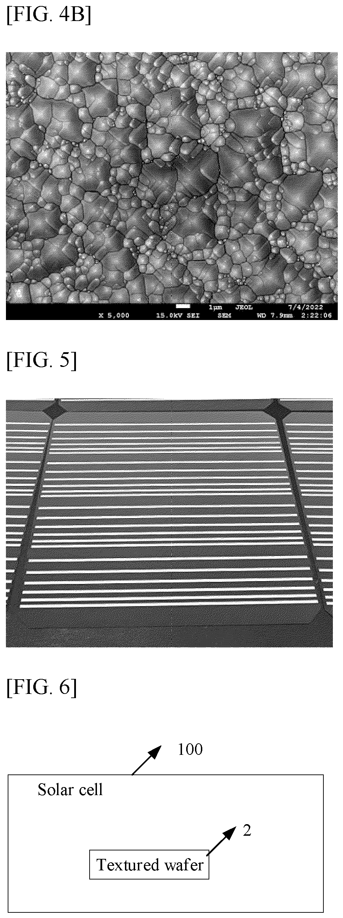

As shown in FIG. 6, an embodiment of this application further provides a solar cell 100, including the textured wafer 2 provided in the embodiments of this application. Due to the use of the textured wafer provided in the embodiments of this application, the solar cell has small internal resistance and high photoelectric conversion efficiency.

In some implementations of this application, the solar cell includes a heterojunction cell. In some specific embodiments, the heterojunction cell includes a conductive oxide layer, a P-type amorphous silicon film layer, an intrinsic hydrogen-rich amorphous silicon film layer, a textured wafer layer, an intrinsic hydrogen-rich amorphous silicon film layer, an N-type amorphous silicon film layer, and a conductive oxide layer that are stacked sequentially. In some implementations, a busbar and finger layer is further provided on the conductive oxide layer.

The amorphous silicon film layer and the conductive oxide layer may be prepared by deposition, and the busbar and finger layer may be prepared by screen printing.

The technical solutions of this application are further described below with multiple examples.

### Example 1

S01: A silicon wafer was cleaned with a cleaning solution 1 at a cleaning temperature of 80°C for cleaning duration of 10 min. The cleaning solution 1 contains hydrogen peroxide and aqueous ammonia, a concentration of the aqueous ammonia is 3 wt%, and a concentration of the hydrogen peroxide is 6 wt%.

S02: The silicon wafer was further cleaned with a cleaning solution 2 at a cleaning temperature of 80°C for cleaning duration of 10 min. The cleaning solution 2 is an aqueous solution of hydrochloric acid and hydrogen peroxide, a concentration of the hydrochloric acid is 4 wt%, and a concentration of the hydrogen peroxide is 6 wt%.

S03: 44 mL of 50 wt% KOH solution and 106 mL of water were mixed to obtain an alkaline polishing solution (with a concentration of KOH of about 20 wt%). The silicon wafer cleaned in S02 was placed in the alkaline polishing solution at 80°C for 60s to obtain a pre-textured silicon wafer. The pre-textured silicon wafer has a pre-textured layer, and a surface of the pre-textured layer has multiple densely arranged protrusions, each of which is in a shape of a quadrangular frustum pyramid.

S04: The pre-textured silicon wafer obtained in S03 was cleaned with a mixed solution of KOH and H₂O₂. A concentration of KOH is about 1 wt%, and a concentration of H₂O₂ is about 5 wt%. A temperature for the cleaning is 65°C, and duration for the cleaning is about 240s.

S05: The cleaned pre-textured silicon wafer was placed in a texturing solution at 80°C for 480s. The texturing solution is a mixed solution of KOH and TS53 (trade name). A concentration of KOH is 2 wt%, and a concentration of TS53 is about 1 wt%.

S06: First post-cleaning. The process parameters are the same as those in S04, and the same pre-cleaning solution is used.

S07: Rounding. An etching solution used is an aqueous solution of concentrated nitric acid and hydrofluoric acid. A percentage by volume of hydrofluoric acid is less than 1%. A temperature for the process is 12°C, and duration for the process is 4 min.

S08: Second post-cleaning. A temperature for the cleaning is 60°C, and duration for the cleaning is 2 min. A cleaning solution used is an aqueous solution of hydrochloric acid and hydrogen peroxide, and concentrations of both the hydrochloric acid and the hydrogen peroxide are 5 wt%.

S09: Passivation with hydrofluoric acid.

S10: A textured wafer was blown dry with nitrogen to obtain the textured wafer in Example 1.

### Example 2

The difference from Example 1 only lies in that, in S03, the alkaline polishing solution is 15 wt% KOH, the duration for alkaline polishing is 60s, and the temperature for alkaline polishing is 65°C. The obtained pre-textured silicon wafer has a pre-textured layer, and a surface of the pre-textured layer has multiple densely arranged protrusions, each of which is in a shape of a quadrangular frustum pyramid.

### Example 3

The difference from Example 1 lies in that, in S03, the alkaline polishing solution is 30 wt% KOH, the duration for alkaline polishing is 60s, and the temperature for alkaline polishing is 65°C. The obtained pre-textured silicon wafer has a pre-textured layer, and a surface of the pre-textured layer has multiple densely arranged protrusions, each of which is in a shape of a quadrangular frustum pyramid.

### Example 4

The difference from Example 1 lies in that, in S03, the duration for alkaline polishing is 40s, where the obtained pre-textured silicon wafer has a pre-textured layer, and a surface of the pre-textured layer has multiple densely arranged protrusions, each of which is in a shape of a quadrangular frustum pyramid; and in S05, the obtained pre-textured silicon wafer is placed in the texturing solution at 80°C for 360s, to obtain the textured wafer provided in Example 5.

### Example 5

The difference from Example 1 lies in that, in S03, the duration for alkaline polishing is 100s. The obtained pre-textured silicon wafer has a pre-textured layer, and a surface of the pre-textured layer has multiple densely arranged protrusions, each of which is in a shape of a quadrangular frustum pyramid.

### Example 6

The difference from Example 1 lies in that, in S03, the temperature for alkaline polishing is 55°C. The obtained pre-textured silicon wafer has a pre-textured layer, and a surface of the pre-textured layer has multiple densely arranged protrusions, each of which is in a shape of a quadrangular frustum pyramid.

### Example 7

The difference from Example 1 lies in that, in S03, the duration for alkaline polishing is 75°C. The obtained pre-textured silicon wafer has a pre-textured layer, and a surface of the pre-textured layer has multiple densely arranged protrusions, each of which is in a shape of a quadrangular frustum pyramid.

To highlight the beneficial effects of the embodiments of this application, the following comparative examples are provided.

### Comparative Example 1

The difference from Example 1 only lies in that, in S03, the alkaline polishing solution is 35 wt% KOH. The obtained pre-textured silicon wafer has a pre-textured layer, and a surface of the pre-textured layer has multiple protrusions, each of which is in a shape of a quadrangular frustum pyramid.

### Comparative Example 2

The difference from Example 1 only lies in that, in S03, the duration for alkaline polishing is 600s. The obtained pre-textured silicon wafer has a pre-textured layer, and a surface of the pre-textured layer has protrusions, each of which is in a shape of a quadrangular frustum pyramid.

### Comparative Example 3

The difference from Example 1 only lies in that, in S03, the pre-textured silicon wafer is obtained at a temperature of 35°C.

### Performance characterization tests

(1) The textured wafers obtained in the examples and comparative examples were detected by using a scanning electron microscope.
(2) A special electrode pattern (as shown in FIG. 5) was printed on the surface of the textured wafer obtained in each example and comparative example, and contact resistance between the textured wafer and a busbar or finger was tested according to the following steps:

An AT510Pro DC resistance meter was used, and the 5^{th} measurement level and the high-current (670 µA) signal source mode were selected, with a maximum measurement range of 300 Ω and a resolution of 10 mΩ. First, the resistance R1 between the first electrode and the second electrode was measured, where the first electrode and the second electrode were 1 mm apart. It may be understood that R1 is equal to the respective contact resistances of the two electrodes plus the resistance of the 1 mm silicon wafer. Then, the resistance R2 between the second electrode and the third electrode was measured, where the second electrode and the third electrode were 2 mm apart. It may be understood that R2 is equal to the respective contact resistances of the two electrodes plus the resistance of the 2 mm silicon wafer. R3, R4, and R5 can be measured in the same way. A curve was plotted for the electrode distance by using R1 to R5. Half of an intercept on the Y axis is the contact resistance.

**Table 1 Summary of parameters and results of the pre-textured silicon wafers and the textured wafers in the examples and comparative examples**

| Experiment number | Length of a bottom edge of a protrusion structure in a shape of a quadrangular frustum pyramid | Length of a bottom edge of a light trapping structure | Observation about morphology of a textured wafer | Contact resistance/Ω·cm³ |
|---|---|---|---|---|
| Example 1 | 5 µm | 2 µm | Uniform size distribution of light trapping structures | 1.00 |
| Example 2 | 4 µm | Slightly greater than 3 µm | Uniform size distribution of light trapping structures | 1.06 |
| Example 3 | 7 µm | Slightly greater than 3 µm | Uniform size distribution of light trapping structures | 1.09 |
| Example 4 | 3 µm | About 2.5 µm | Few cutting lines left | 1.08 |
| Example 5 | 8 µm | Slightly greater than 3 µm | Uniform size distribution of light trapping structures | 1.09 |
| Example 6 | 4 µm | Slightly greater than 3 µm | Few cutting lines left | 1.03 |
| Example 7 | 7 µm | Slightly greater than 3 µm | Uniform size distribution of light trapping structures | 1.11 |
| Comparative Example 1 | 20 µm | Varying within 1 µm to 5 µm | Apparently non-uniform size distribution of light trapping structures | 1.25 |
| Comparative Example 2 | 10 µm | Varying within 1 µm to 3 µm | Apparently non-uniform size distribution of light trapping structures | 1.32 |
| Comparative Example 3 | No protrusion structure in a shape of a quadrangular frustum pyramid | Varying within 1 µm to 5 µm | Many cutting lines left | 1.19 |

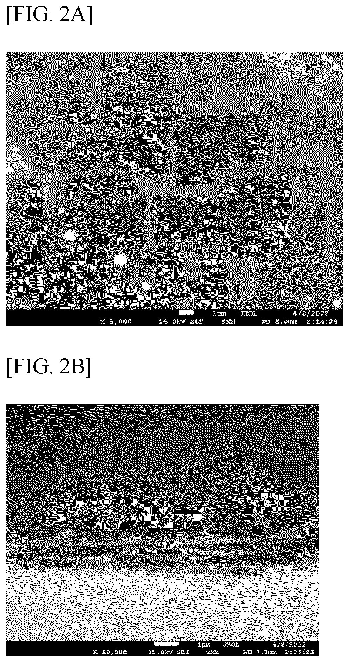

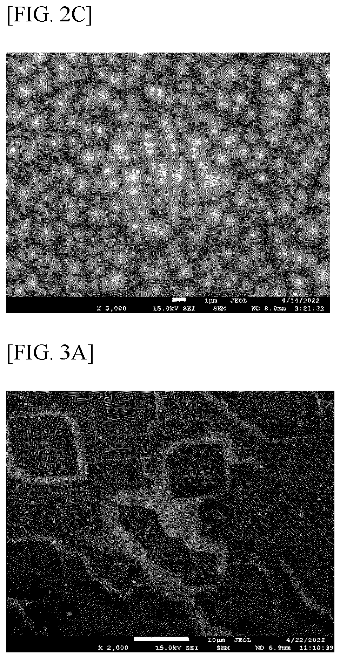

FIG. 2A is an SEM image of the pre-textured silicon wafer obtained in Example 1 in this application. FIG. 2B is an SEM image of a cross-section of the pre-textured silicon wafer obtained in Example 1 in this application. It can be learned from FIG. 2A that a length of a bottom edge of each protrusion is about 5 µm, and small white spots (nucleation sites) are distributed on side walls of protrusions. It can be learned from FIG. 2B that each protrusion has a small height and tends to be a flat structure, and a damage layer of the silicon wafer has been completely removed. The textured wafer (as shown in FIG. 2C) obtained from the pre-textured silicon wafer has a textured surface layer, on which light trapping structures each with a length of a bottom edge of about 2 µm are densely arranged, and size distribution of the light trapping structures is uniform. Therefore, the textured surface layer has high flatness, which can also be learned from the data of contact resistance in Table 1.

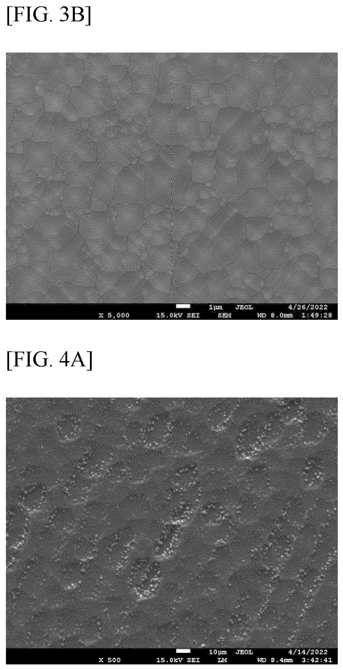

FIG. 3A and FIG. 3B are SEM images of the pre-textured silicon wafer and the textured wafer respectively obtained in Example 5 in this application. It can be learned that a length of a bottom edge of a protrusion of the pre-textured silicon wafer is about 8 µm, a length of a bottom edge of a light trapping structure is about 3 µm, and distribution of lengths of bottom edges of multiple light trapping structures is relatively uniform.

However, the pre-textured silicon wafers and textured wafers obtained in the comparative examples are apparently inferior to those obtained in the examples. FIG. 4A and FIG. 4B are SEM images of the pre-textured silicon wafer and the textured wafer respectively obtained in Comparative Example 1. A length of a bottom edge of a protrusion of the pre-textured silicon wafer is about 20 µm, a length of a bottom edge of a light trapping structure is 1 µm to 5 µm, distribution of lengths of bottom edges of multiple light trapping structures is very non-uniform, and a textured surface layer has low surface flatness and large contact resistance with a busbar or finger (see the data in Table 1).

The foregoing descriptions are exemplary implementations of this application. It should be noted that, a person of ordinary skill in the art can further make several improvements and refinements without departing from the principle of this application, and these improvements and refinements shall fall within the protection scope of this application.

## Claims

1. A pre-textured silicon wafer (1), wherein the pre-textured silicon wafer comprises a substrate layer (10) and a pre-textured layer provided on a surface of at least one side of the substrate layer, the pre-textured layer comprises a plurality of protrusions (201), the protrusions (201) each are in a shape of a quadrangular frustum pyramid, and a length of a bottom edge of the protrusion ranges from 2 µm to 8 µm.

2. The pre-textured silicon wafer according to claim 1, wherein nucleation sites (202) are distributed on a side wall (A/B) of the protrusion (201).

3. The pre-textured silicon wafer according to claim 2, wherein the nucleation site (202) is a quadrangular pyramid with a maximum cross-sectional width ranging from 0 µm to 1 µm and a height ranging from 0 µm to 0.75 µm.

4. The pre-textured silicon wafer according to any one of claims 1 to 3, wherein the pre-textured layer comprises 2 to 11 protrusions (201) per 100 µm².

5. The pre-textured silicon wafer according to any one of claims 1 to 4, wherein a height of the protrusion (201) ranges from 0.5 µm to 2 µm.

6. The pre-textured silicon wafer according to any one of claims 1 to 5, wherein a cross-sectional size of the protrusion (201) gradually decreases in a direction facing away from the substrate layer.

7. A method for preparing a pre-textured silicon wafer, comprising the following steps:
subjecting a silicon wafer to sequential cleaning and alkaline polishing treatment to obtain the pre-textured silicon wafer, wherein the pre-textured silicon wafer comprises a substrate layer and a pre-textured layer provided on a surface of at least one side of the substrate layer, the pre-textured layer comprises a plurality of protrusions, and the protrusions each are in a shape of a quadrangular frustum pyramid; and
the alkaline polishing treatment comprises the following conditions: the silicon wafer is subjected to alkaline etching with a strong alkali solution of 15 wt% to 30 wt%; and duration for the alkaline polishing treatment is 40s to 120s, and a temperature for the alkaline polishing treatment is 50°C to 80°C.

8. The method for preparing the pre-textured silicon wafer according to claim 7, wherein the subjecting the silicon wafer to sequential cleaning comprises:
cleaning the silicon wafer with a first cleaning solution at a cleaning temperature of 60°C to 90°C for cleaning duration of 5 min to 20 min, wherein the first cleaning solution contains hydrogen peroxide and aqueous ammonia, a concentration of the aqueous ammonia is about 2 wt% to 10 wt%, and a concentration of the hydrogen peroxide is about 2 wt% to 10 wt%; and
further cleaning the silicon wafer with a second cleaning solution at a cleaning temperature of 60°C to 90°C for cleaning duration of 5 min to 20 min, wherein the second cleaning solution is an aqueous solution of hydrochloric acid and hydrogen peroxide, and concentrations of both the hydrochloric acid and the hydrogen peroxide are 2 wt% to 10 wt%.

9. A textured wafer (2), wherein the textured wafer is prepared from the pre-textured silicon wafer according to any one of claims 1 to 6.

10. The textured wafer according to claim 9, wherein the textured wafer comprises a substrate layer and a textured surface layer provided on a surface of at least one side of the substrate layer, the textured surface layer comprises densely arranged light trapping structures, and a maximum cross-sectional width of the light trapping structure ranges from 1 µm to 4 µm.

11. The textured wafer according to claim 10, wherein the light trapping structure is in a shape of a quadrangular pyramid; and a maximum cross-sectional size of the light trapping structure gradually decreases in a direction facing away from the substrate layer.

12. The textured wafer according to claim 10 or 11, wherein the textured surface layer comprises 60 to 100 light trapping structures per 100 µm².

13. The textured wafer according to any one of claims 10 to 12, wherein a height of the light trapping structure ranges from 1.23 µm to 1.58 µm.

14. The textured wafer according to any one of claims 10 to 13, wherein adjacent light trapping structures are arranged at no interval.

15. A solar cell (100), wherein the solar cell comprises the textured wafer (2) according to any one of claims 9 to 14.
